(19) Europäisches Patentamt
European Patent Office
Office européen des brevets

(11) **EP 1 454 370 B1**

(12) **FASCICULE DE BREVET EUROPEEN**

(45) Date de publication et mention
de la délivrance du brevet:
**28.03.2012 Bulletin 2012/13**

(21) Numéro de dépôt: **02801128.6**

(22) Date de dépôt: **12.12.2002**

(51) Int Cl.:
*H01L 33/00* *(2010.01)*

(86) Numéro de dépôt international:
**PCT/FR2002/004330**

(87) Numéro de publication internationale:
**WO 2003/050887 (19.06.2003 Gazette 2003/25)**

(54) **DISPOSITIF D EMISSION DE LUMIERE ET PROCEDE DE FABRICATION D    UN TEL DISPOSITIF**

LICHTEMITTIERENDE VORRICHTUNG UND HERSTELLUNGSVERFAHREN

LIGHT EMITTING DEVICE AND METHOD FOR MAKING SAME

(84) Etats contractants désignés:
**DE FR GB IT**

(30) Priorité: **13.12.2001 FR 0116116**

(43) Date de publication de la demande:
**08.09.2004 Bulletin 2004/37**

(73) Titulaire: **Commissariat à l'Énergie Atomique et aux Énergies Alternatives**
**75015 Paris (FR)**

(72) Inventeurs:
• **PICARD, Emmanuel**
**F-38410 Saint Martin d'Uriage (FR)**
• **HADJI, Emmanuel**
**F-38600 Fontaine (FR)**
• **ZANATTA, Jean-Paul**
**F-38000 Grenoble (FR)**

(74) Mandataire: **Poulin, Gérard et al**
**BREVALEX**
**95, rue d'Amsterdam**
**75378 Paris Cedex 8 (FR)**

(56) Documents cités:
• **CORBETT B ET AL: "RESONANT CAVITY LIGHT EMITTING DIODE AND DETECTOR USING EPITAXIAL LIFTOFF" IEEE PHOTONICS TECHNOLOGY LETTERS, IEEE INC. NEW YORK, US, vol. 5, no. 9, 1 septembre 1993 (1993-09-01), pages 1041-1043, XP000414173 ISSN: 1041-1135**
• **ROUX C ET AL: "II-VI infrared microcavity emitters with 2 postgrowth dielectric mirrors" JOURNAL OF CRYSTAL GROWTH, NORTH-HOLLAND PUBLISHING CO. AMSTERDAM, NL, vol. 201-202, mai 1999 (1999-05), pages 1036-1039, XP004175293 ISSN: 0022-0248**
• **PATENT ABSTRACTS OF JAPAN vol. 1995, no. 02, 31 mars 1995 (1995-03-31) & JP 06 314845 A (SANKEN ELECTRIC CO LTD), 8 novembre 1994 (1994-11-08)**
• **E.HADJI ET AL.: "3.3-micrometer microcavity light emitter for gas detection", OPTICS LETTERS, vol. 25, no. 10, 15 May 2000 (2000-05-15), pages 725-727,**

**Description**

**DOMAINE TECHNIQUE**

La présente invention concerne un dispositif d'émission de lumière à micro-cavité ainsi qu'un procédé de fabrication de ce dispositif.

L'invention concerne plus particulièrement un dispositif d'émission de lumière à micro-cavité, dans le domaine infrarouge moyen, qui va de 2 $\mu$m à 6 $\mu$m, et un procédé de fabrication d'un tel dispositif.

L'invention s'applique notamment

- à la détection de gaz tels que les gaz polluants ou à effet de serre, plus particulièrement dans le domaine de l'industrie automobile (mesure de la concentration de gaz d'échappement) et dans le domaine de la climatologie (mesure du dioxyde de carbone dans l'atmosphère), et
- au tri automatique des plastiques qui absorbent également dans l'infrarouge à des longueurs d'ondes différentes selon leur composition.

**ETAT DE LA TECHNIQUE ANTERIEURE**

Un dispositif d'émission de lumière à micro-cavité est un dispositif de type plan (en anglais "planar"), comprenant une structure émettrice que l'on photo-pompe grâce à une diode laser.

Cette structure émettrice comprend une partie active à base de matériaux semiconducteurs, qui est insérée dans une micro-cavité. Cette dernière est délimitée par deux miroirs diélectriques (par exemple deux miroirs de Bragg) qui sont rapportés sur la partie active.

L'ensemble de la micro-cavité et des deux miroirs repose sur un support mécanique.

La longueur de la micro-cavité est très faible, de l'ordre de quelques demi-longueurs d'onde, et détermine la longueur d'onde de la lumière émise.

Ce type de dispositif permet de n'avoir qu'un seul mode résonant à la longueur d'onde choisie.

Au sujet de tels dispositifs, émettant dans le domaine infrarouge moyen, on se reportera par exemple au document suivant :

E. Hadji et al., Optics Lett., Vol. 25, N°10, 2000, pp. 725-727.

On connaît plusieurs techniques de fabrication de ce genre de composant à micro-cavité.

Selon une première technique connue, la partie active est épitaxiée directement sur un substrat cristallin. Ensuite, le premier des deux miroirs est déposé directement sur cette partie active mais le deuxième miroir ne peut être déposé qu'après ablation locale du substrat.

A ce sujet, on se reportera par exemple au document suivant :

K. Iga et al., IEEE J. of Quant. Electr., Vol. 24, N°9, 1998, pp. 1845-1853.

Cette technique connue nécessite l'emploi d'une couche d'arrêt pour la gravure du substrat, gravure qui doit s'arrêter à l'interface entre le substrat et la partie active épitaxiée sur ce substrat.

Cette technique peut être mise en oeuvre avec le silicium et les semi-conducteurs III-V mais de tels matériaux émettent à des longueurs d'ondes inférieures à 1,5 $\mu$m. Pour pouvoir travailler dans le domaine infrarouge moyen (qui va de 3 $\mu$m à 6 $\mu$m) il faut utiliser des matériaux à base de mercure ou d'antimoine.

On peut alors reproduire la technique de gravure du substrat mais avec une couche d'arrêt adaptée aux matériaux utilisés, par exemple une couche d'arrêt en HgTe.

L'ablation du substrat doit être faite avec une extrême précision car il faut l'arrêter à l'interface entre le substrat et la structure épitaxiée sur ce substrat. Pour ce faire, on utilise une méthode de gravure chimique qui permet une attaque sélective en fonction du matériau. Pour éliminer le substrat, on prévoit encore une couche d'arrêt qui stoppe l'attaque chimique du substrat.

Cette élimination du substrat est fondée sur le fait qu'il existe une grande sélectivité d'attaque chimique entre CdTe et HgTe. Dans le cas des émetteurs infrarouges à micro-cavité, HgTe est donc un bon matériau d'arrêt. Cependant, une couche d'arrêt en HgTe est très absorbante et diminue notablement l'efficacité optique de la micro-cavité.

Selon une deuxième technique connue, la partie active est êpitaxiée sur un miroir cristallin de même nature, lui-même épitaxié sur un substrat qui supporte mécaniquement l'ensemble de la structure.

A ce sujet, on se reportera par exemple au document suivant :

E. Hadji et al., Appl. Phys. Lett., Vol. 67, N°18, 1995, pp. 2591-2593.

La fabrication de ce miroir est longue du fait de la faible vitesse de croissance cristalline. De plus, l'épitaxie nécessite d'accorder le paramètre cristallin des différentes couches du miroir, ce qui limite le choix des matériaux utilisables.

**EXPOSÉ DE L'INVENTION**

La présente invention a pour but de remédier aux inconvénients de ces techniques connues.

De façon précise, l'invention a pour objet un dispositif d'émission de lumière conformément à la revendication 1.

L'invention a également pour objet un procédé de fabrication d'un dispositif d'émission de lumière conformément à la revendication 3.

Selon un mode de mise en oeuvre préféré du procédé objet de l'invention, la gravure est une gravure chimique.

Selon un mode de mise en oeuvre particulier du procédé objet de l'invention, l'élimination du substrat comporte en outre un polissage de ce substrat avant la gravure de ce dernier.

De préférence, le matériau de la couche émettrice est choisi pour que la lumière émise par cette couche émettrice soit un rayonnement infrarouge dont la longueur d'onde est comprise dans l'intervalle allant de 2 $\mu$m à 6 $\mu$m.

Selon un mode de mise en oeuvre préféré de l'invention, l'épaisseur de la couche d'arrêt de gravure est inférieure à 50 nm.

On peut fixer le premier miroir à un support qui est transparent à à lumière de pompage optique.

Du fait que la couche d'arrêt de gravure a la même composition que la couche émettrice, ce dispositif présente des avantages :

Non seulement les photons émis par cette couche émettrice ne sont par absorbés par la couche d'arrêt de gravure mais encore cette dernière participe à l'émission lumineuse induite par le pompage optique.

L'efficacité du dispositif objet de l'invention est ainsi supérieure à celle des dispositifs à micro-cavité connus.

## BRÈVE RESCRIPTION DES DESSINS

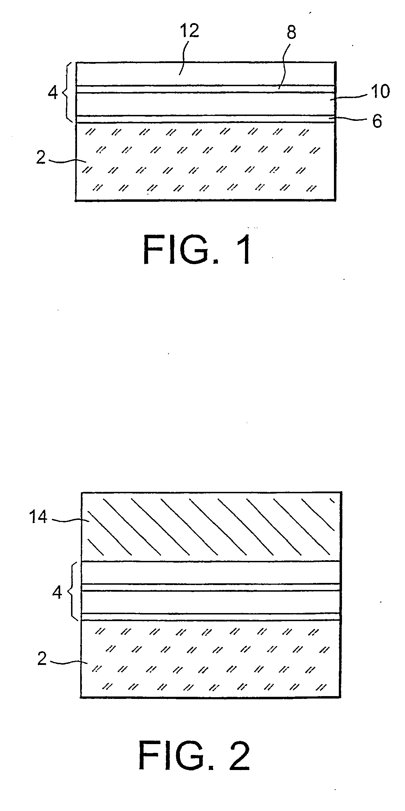

La présente invention sera mieux comprise à la lecture de la description d'exemples de réalisation donnés ci-après, à titre purement indicatif et nullement limitatif, en faisant référence aux dessins annexés sur lesquel les figures 1 à 5 illustrent schématiquement des étapes d'un mode de mise en oeuvre particulier du procédé objet de l'invention.

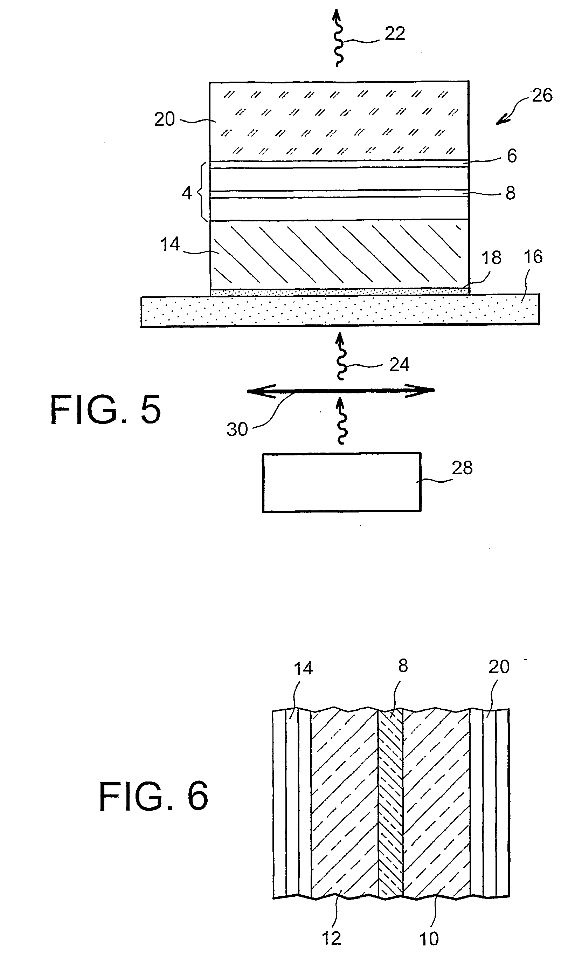

La figure 6 est une vue en coupe schématique d'un exemple de dispositif d'émission de lumière conforme à l'invention.

## EXPOSÉ DÉTAILLÉ DE MODES DE RÉALISATION PARTICULIERS

Pour mettre en oeuvre cet exemple de procédé conforme à l'invention, on commence par former, sur un substrat 2 (figure 1), une structure émettrice, apte à engendrer un rayonnement infrarouge lorqu'elle est pompée optiquement.

Cette structure émettrice comprend une partie active 4 et une micro-cavité qui est délimitée par deux miroirs (dont il sera question plus loin) et contient la partie active 4.

Cette partie active est un empilement comprenant :

- une couche 6 formant une couche d'arrêt de gravure du substrat et se trouvant à l'interface de la partie active et du substrat et donc en contact avec ce substrat,

- une couche de puits formant une couche émettrice 8, apte à émettre le rayonnement infrarouge lorsqu'elle est pompée optiquement à travers l'un des miroirs, ou miroir de fond, et

- des première et deuxième couches de barrière 10 et 12.

Conformément à l'invention, la couche émettrice 8 est faite d'un matériau qui est à la fois apte à émettre le rayonnement infrarouge et apte à arrêter la gravure du substrat 2 et la couche d'arrêt de gravure 6 est faite de ce matériau.

Dans l'exemple de la figure 1,

- le substrat 2 est en CdZnTe et a une épaisseur de 750 $\mu$m,

- la couche émettrice 8 est en $Cd_xHg_{1-x}Te$ et chacune des couches de barrière est en $Cd_yHg_{1-y}Te$, avec $y>x$, et

- la couche d'arrêt de gravure 6 est aussi en $Cd_xHg_{1-x}Te$.

On fixe la composition de la couche émettrice, et donc la valeur de x, en fonction de la longueur d'onde $\lambda$ du rayonnement à émettre (longueur d'onde de résonance de la micro-cavité).

De préférence, on choisit x et y tels que :

$$0,1 < x < 0,5 \text{ et } 0,6 < y < 1.$$

A titre purement indicatif et nullement limitatif, x est égal à 0,31 et y à 0,65.

L'épaisseur de la partie active 4 (empilement de l'ensemble des couches 6 à 12) est de préférence comprise entre $\lambda/(2n)$ et $10\lambda/(2n)$ et vaut par exemple $\lambda/n$, où n est l'indice moyen de réfraction de l'empilement 4 des couches 6, 8, 10 et 12.

L'épaisseur de la couche d'arrêt de gravure 6 est aussi faible que possible, de préférence inférieure à 50 nm, et vaut par exemple 35 nm.

Cette couche d'arrêt de gravure en $Cd_xHg_{1-x}Te$ participe à l'émission du rayonnement infrarouge sans absorber ce rayonnement.

On augmente ainsi fortement l'efficacité optique du dispositif par rapport à celle des dispositifs de l'art antérieur.

Pour former la structure émettrice, on forme d'abord, par épitaxie, l'empilement des couches 6 à 12 sur le substrat 2.

On forme ensuite, sur la couche 12, un miroir de Bragg 14 (figure 2) appelé "miroir de fond", dont la réflectivité (vis-à-vis du rayonnement engendré par la partie active) est très grande et par exemple égale à 98%.

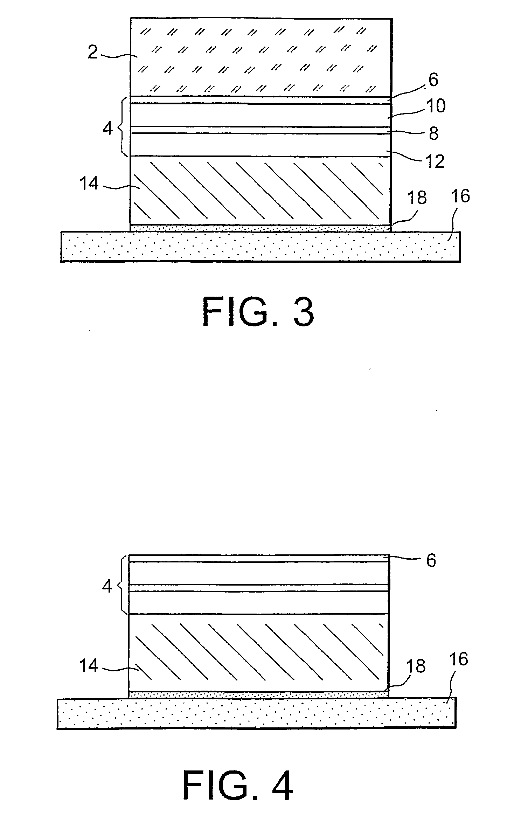

On colle ensuite ce miroir de fond 14 sur un support formé par une lame de silice 16 (figure 3) dont l'épaisseur vaut par exemple 300 $\mu$m, au moyen d'une couche de colle en résine époxy 18 qui est transparente à la lumière destinée au pompage optique de la structure émettrice.

On élimine ensuite le substrat 2. On commence par enlever 600 μm de ce dernier par polissage mécanique. On grave ensuite chimiquement les 150 μm restants (figure 4). Pour ce faire, on utilise une gravure chimique sélective qui élimine le matériau du substrat 2 et s'arrête sur la couche 6.

Cette gravure est réalisée au moyen d'un mélange d'acides. Dans l'exemple où le substrat est en CdZnTe, on utilise une solution à base d'acide fluorhydrique, d'acide nitrique et d'acide acétique.

Pour obtenir cette solution, on mélange par exemple 1 volume d'acide fluorhydrique, 1 volume d'acide nitrique et 4 volumes d'acide acétique.

On forme ensuite un autre miroir de Bragg 20 appelé "miroir de sortie" sur la couche 6, par un dépôt approprié (figure 5) .

La réflectivité de ce miroir 20 vaut par exemple 60% vis-à-vis du rayonnement 22 émis par la partie active 4, dont la longueur d'onde λ vaut par exemple 3,3 μm.

On précise que la réflectivité du miroir de fond 14 est très faible vis-à-vis de la lumière de pompage optique 24 dont la longueur d'onde vaut par exemple 0,83 μm.

La structure émettrice ainsi obtenue, comportant une micro-cavité délimitée par les miroirs 14 et 20, constitue un dispositif d'émission de lumière 26 conforme à l'invention.

Pour faire fonctionner ce dispositif 26, ce dernier est pompé optiquement par une diode laser 28 à travers le miroir de fond 14, soit directement soit par l'intermédiaire d'une lentille de focalisation 30.

En ce qui concerne les miroirs 14 et 20, on précise que le miroir 14 (respectivement 20) est formé par dépôt d'un empilement de couches élémentaires sur la couche 12 (respectivement 6).

Chacune de ces couches élémentaires a une épaisseur égale à λ/(4n), λ et n étant définis plus haut.

De plus, dans chaque empilement, on fait alterner des couches élémentaires différentes l'une de l'autre de sorte que chaque miroir est un empilement de paires de couches élémentaires différentes, chaque paire comprenant par exemple une couche de $YF_3$ de 365 nm d'épaisseur et une couche de ZnS de 565 nm d'épaisseur.

La réflectivité de ce genre de miroir est une fonction croissante du nombre de couches élémentaires.

En ce qui concerne le miroir 14, pour obtenir une réflectivité de 98%, il suffit, d'empiler 6 paires de couches du genre $YF_3$ (365 nm)/ZnS (565 nm).

En particulier, on a décrit plus haut un exemple de dispositif conforme à l'invention comprenant, sur le substrat 2, l'empilement des couches 6, 10, 8 et 12. On obtient aussi un dispositif conforme à l'invention en formant un tel empilement (comprenant une couche émettrice de lumière entre des première et deuxième couches de barrière et une couche d'arrêt de gravure entre le substrat et la première couche de barrière) dans lequel la couche d'arrêt est de même nature que la couche émettrice, en $Cd_xHg_{1-x}Te$.

On expose ci-après des modes de réalisation avantageux de la présente invention.

L'utilisation de $Cd_xHg_{1-x}Te$ en tant que matériau émetteur impose l'utilisation d'une couche d'arrêt de gravure en HgTe. Cependant HgTe absorbe les photons qui sont présents dans la cavité résonnante d'un dispositif d'émission de lumière ainsi obtenu et, de ce fait, diminue notablement le rendement du dispositif. C'est pourquoi, conformément à l'invention, on ajoute, au matériau HgTe mentionné ci-dessus, du cadmium dans des proportions particulières qui conduisent aux résultats inattendus suivants : la couche de $Cd_xHg_{1-x}Te$ devient apte à constituer une couche d'arrêt de gravure et non seulement cette couche n'absorbe plus les photons émis mais encore elle participe à l'émission de lumière.

Donnons des précisions sur ce qui précède, en commençant par considérer les problèmes qui se posent dans l'art antérieur puis en expliquant comment on résout ces problèmes dans des modes de réalisation avantageux de la présente invention.

Pour fabriquer un dispositif qui émet de la lumière du domaine infrarouge moyen, on utilise du CdHgTe en tant que matériau émetteur. Or on a besoin de graver le substrat du dispositif et, de ce fait, une couche d'arrêt de gravure est nécessaire.

On sait qu'une telle couche d'arrêt de gravure peut être faite de HgTe mais on sait également que l'utilisation de ce matériau conduit à la diminution du rendement du dispositif.

En effet, on sait que la largeur de bande interdite de HgTe est nulle. Toutes les longueurs d'ondes lumineuses sont donc absorbées par HgTe.

Dans la présente invention, on souhaite de préférence que la totalité de l'énergie fournie par un laser de pompe (par exemple une diode laser de pompe), associé à une structure de dispositif conforme à l'invention, soit absorbée par la structure.

Or la couche de HgTe, qui est présente dans cette structure, absorbe notablement les photons de sorte que le rendement du dispositif diminue.

La figure 6 est une vue en coupe très schématique d'un exemple de dispositif d'émission de lumière conforme à l'invention. On voit les deux miroirs 14 et 20 qui délimitent la cavité résonnante du dispositif et, dans cette cavité, une couche émettrice 8, par exemple en $Cd_xHg_{1-x}Te$, et deux couches de barrière 10 et 12, par exemple en $Cd_yHg_{1-y}Te$, qui sont respectivement disposées de part et d'autre de la couche émettrice 8. Pour la couche émettrice 8, on a par exemple : 0,35<x<0,45.

Pour les couches de barrière, on choisit y supérieur à x et par exemple égal à 0,65 de sorte que le matériau constitutif de ces couches est transparent aux photons.

De plus, la cavité est calculée de manière à amplifier la lumière émise par la couche émettrice.

Or, on a besoin de placer, contre le miroir 20, une couche d'arrêt de gravure (non représentée sur la figure 6) qui selon l'art antérieur serait en HgTe, couche qui absorberait les photons engendrés dans la cavité résonnante.

On précise plus que l'on souhaite avoir une résonnance aussi grande que possible et donc un facteur de qualité aussi proche de 100 que possible. Il en résulte un grand nombre d'allers et retours des photons dans la cavité. Or, à chaque aller et retour, la couche de HgTe absorbe des photons. Donc plus le facteur de qualité souhaité est important, plus le nombre des photons absorbés est élevé.

Il convient de noter que, dans la présente invention, on souhaite de préférence disposer d'une couche d'arrêt de gravure qui ne détériore pas le rendement du dispositif.

C'est pourquoi dans la présente invention la couche d'arrêt de gravure et la couche émettrice sont toutes deux en $Cd_xHg_{1-x}Te$.

Ainsi les auteurs de la présente invention on trouvé de façon surprenante qu'une couche émettrice en $Cd_xHg_{1-x}Te$ peut servir de couche d'arrêt de gravure (x étant typiquement inférieur à 0,50).

En outre, ils ont trouvé de façon surprenante que la couche d'arrêt de gravure participe à l'émission de lumière.

## Revendications

1. Dispositif d'émission de lumière comportant un empilement qui comprend :

 - un substrat (2),
 - une couche d'arrêt de gravure (6) sur ce substrat,
 - une première couche de barrière (10) sur cette couche d'arrêt,
 - une couche émettrice de lumière (8) en $Cd_xHg_{1-x}Te$ sur cette première couche de barrière, et
 - une deuxième couche de barrière (12) sur cette couche émettrice,

 ce dispositif étant **caractérisé en ce que** la couche d'arrêt de gravure est faite du même matériau $Cd_xHg_{1-x}Te$ que la couche émettrice et a la même composition que celle-ci.

2. Dispositif selon la revendication 1, dans lequel on choisit x tel que : 0,1<x<0,5.

3. Procédé de fabrication d'un dispositif (26) d'émission de lumière, ce dispositif comprenant une partie active (4) et une micro-cavité, délimitée par des premier et deuxième miroirs (14, 20) et contenant la partie active, cette partie active étant formée sur un substrat et comportant une couche d'arrêt de gravure (6) à l'interface de cette partie active avec le substrat, ainsi qu'une couche émettrice (8) en $Cd_xHg_{1-x}Te$, apte à émettre la lumière (22) lorsqu'elle est optiquement pompée à travers le premier miroir (14), procédé dans lequel on forme le premier miroir (14) sur la partie active, on élimine le substrat par gravure, et l'on forme le deuxième miroir (20) sur la partie active,

 ce procédé étant **caractérisé en ce que** la couche d'arrêt de gravure (6) est faite du même matériau $Cd_xHg_{1-x}Te$ que la couche émettrice et a la même composition que celle-ci.

4. Procédé selon la revendication 3, dans lequel on choisit x tel que : 0,1<x<0,5.

5. Procédé selon l'une quelconque des revendications 3 et 4, dans lequel la gravure est une gravure chimique.

6. Procédé selon l'une quelconque des revendications 3 à 5, dans lequel l'élimination du substrat (2) comporte en outre un polissage de ce substrat avant la gravure de ce dernier.

7. Procédé selon l'une quelconque des revendications 3 à 6, dans lequel le matériau de la couche émettrice (8) est choisi pour que la lumière (22) émise par cette couche émettrice soit un rayonnement infrarouge dont la longueur d'onde est comprise dans l'intervalle allant de 2 $\mu$m à 6 $\mu$m.

8. Procédé selon l'une quelconque des revendications 3 à 7, dans lequel l'épaisseur de la coucha d'arrêt de gravure (6) est inférieure à 50 nm.

9. Procédé selon l'une quelconque des revendications 3 à 8, dans lequel on fixe le premier miroir (14) à un support (16) qui est transparent à la lumière de pompage optique (24).

## Claims

1. Light emission device comprising a stack that comprises:

 - a substrate (2),
 - an etching stop layer (6) on said substrate,
 - a first barrier layer (10) on said stop layer,
 - a light emitting layer (8) of $Cd_xHg_{1-x}Te$ on said first barrier layer, and
 - a second barrier layer (12) on said emitting layer,

 said device being **characterised in that** the etching stop layer is made of the same $Cd_xHg_{1-x}Te$ material as the emitting layer and has the same composition as the latter.

2. Device according to claim 1, wherein one chooses x so that : 0,1 < x < 0,5.

3. Method for producing a light emitting device (26), said device comprising an active part (4) and a micro-cavity, delimited by first and second mirrors (14, 20) and containing the active part, said active part being formed on a substrate and comprising an etching stop layer (6) at the interface of said active part with the substrate, as well as an emitting layer (8) of $Cd_xHg_{1-x}Te$ suited to emitting light (22) when it is optically pumped through the first mirror (14), method in which one forms the first mirror (14) on the active part, one eliminates the substrate by etching, and one forms the second mirror (20) on the active part,
said method being **characterised in that** the emitting layer (8) is made out of the same material $Cd_xHg_{1-x}Te$ as the emitting layer and has the same composition as the latter.

4. Method according to claim 3, wherein one chooses x so that : 0,1 < x < 0,5.

5. Method according to any of claims 3 and 4, in which the etching is a chemical etching.

6. Method according to any of claims 3 to 5, in which the elimination of the substrate (2) comprises in addiction a polishing of said substrate before the etching of the latter.

7. Method according to any of claims 3 to 6, in which the material of the emitting layer (8) is chosen so that the light (22) emitted by said emitting layer is an infrared radiation whose wavelength is in the range extending from 2 $\mu$m to 6 $\mu$m.

8. Method according to any of claims 3 to 7, in which the thickness of the etching stop layer (6) is less than 50 nm.

9. Method according to any of claims 3 to 8, in which one fastens the first mirror (14) to a support (16) which is transparent to the optical pumping light (24).

**Patentansprüche**

1. Vorrichtung zur Emission von Licht, umfassend einen Stapel, der umfasst:

- ein Substrat (2),
- eine Ätzstoppschicht (6) auf dem Substrat,

- eine erste Barrierenschicht (10) auf der Stoppschicht,
- eine Lichtemissionsschicht (8) aus $Cd_xHg_{1-x}Te$ auf der ersten Barrierenschicht, und
- eine zweite Barrierenschicht (12) auf der Emissionsschicht,

wobei die Vorrichtung **dadurch gekennzeichnet ist, dass** die Ätzstoppschicht aus dem gleichen Ma-terial $Cd_xHg_{1-x}Te$ hergestellt ist wie die Emissionsschicht und die gleiche Zusammensetzung wie diese aufweist.

2. Vorrichtung nach Anspruch 1, wobei x derart ausgewählt ist das 0,1 < x < 0,5.

3. Verfahren zur Herstellung einer Vorrichtung (26) zur Emission von Licht, wobei die Vorrichtung einen aktiven Teil (4) und eine Mikrokavität umfasst, die durch einen ersten und einen zweiten Spiegel (14, 20) begrenzt ist und den aktiven Teil enthält, wobei dieser aktive Teil auf einem Substrat gebildet wird, und eine Ätzstoppschicht (6) an der Schnittstelle von dem aktiven Teil mit dem Substrat umfasst, sowie eine Emissionsschicht (8) aus $Cd_xHg_{1-x}Te$, die dazu geeignet ist, das Licht (22) zu emittieren, wenn sie über den ersten Spiegel (14) optisch gepumpt wird, wobei in dem Verfahren der erste Spiegel (14) auf dem aktiven Teil gebildet wird, das Substrat durch Ätzen entfernt wird und der zweite Spiegel (20) auf dem aktiven Teil gebildet wird, wobei das Verfahren **dadurch gekennzeichnet ist, dass** die Ätzstoppschicht (6) aus dem gleichen Material $Cd_xHg_{1-x}Te$ hergestellt wird wie die Emissionsschicht und die gleiche Zusammensetzung wie diese aufweist.

4. Verfahren nach Anspruch 3 wobei x derart ausgewählt ist das 0,1 < x < 0,5.

5. Verfahren nach einem der Ansprüche 3 und 4, wobei das Ätzen ein chemisches Ätzen ist.

6. Verfahren nach einem der Ansprüche 3 bis 5, wobei das Entfernen des Substrats (2) weiter ein Polieren des Substrats vor dem Ätzen des Letzteren umfasst.

7. Verfahren nach einem der Ansprüche 3 bis 6, wobei das Material der Emissionsschicht (8) ausgewählt wird, so dass das von der Emissionsschicht emittierte Licht (22) eine Infrarotstrahlung ist, deren Wellenlänge im Intervall liegt, welches von 2 $\mu$m bis 6 $\mu$m reicht.

8. Verfahren nach einem der Ansprüche 3 bis 7, wobei die Dicke der Ätzstoppschicht (6) kleiner als 50 nm ist.

9. Verfahren nach einem der Ansprüche 3 bis 8, wobei der erste Spiegel (14) auf einem Träger (16) fixiert wird, der transparent für das Licht zum optischen Pumpen (24) ist.

FIG. 1

FIG. 2

FIG. 3

FIG. 4

FIG. 5

FIG. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **E. HADJI et al.** *Optics Lett.,* 2000, vol. 25 (10), 725-727
- **K. IGA et al.** *IEEE J. of Quant. Electr.,* 1998, vol. 24 (9), 1845-1853
- **E. HADJI et al.** *Appl. Phys. Lett.,* 1995, vol. 67 (18), 2591-2593